# EUROPEAN PATENT APPLICATION

(11) **EP 2 631 961 A1**
(43) Date of publication of application: **28.08.2013**
(21) Application number: 10858542.3
(22) Date of filing: 20.10.2010
(51) Int. Cl.: H01L 51/50, H01L 51/52, H01L 51/54, H01L 51/56

(54) **ORGANIC ELECTROLUMINESCENT DEVICE AND MANUFACTURING METHOD THEREOF**

(71) Applicant: Ocean's King Lighting Science&Technology Co., Ltd., Guangdong 518054 (CN)
(72) Inventor: ZHOU, Mingjie, Guangdong 518054 (CN); WANG, Ping, Guangdong 518054 (CN); HUANG, Hui, Guangdong 518054 (CN); FENG, Xiaoming, Guangdong 518054 (CN)
(74) Representative: Noel, Chantal Odile
(86) International application number: PCT/CN2010/077897
(87) International publication number: WO 2012/051754

(57) **Abstract**

An organic electroluminescent device and a method of manufacture thereof are provided. The device comprises a conductive substrate, a hole-injecting layer, a light-emitting layer, and a cathode layer, which are stacked in order. The material of the hole-injecting layer is made of an acid-doped polyaniline. The polyaniline has good conductivity and high stability, and the polyaniline is suitable as the material of hole-injecting layer. The acid-doped polyaniline can significantly improve the solubility and conductivity. As a result of the acid-doped polyaniline as the hole-injecting layer, the light-emitting performance of the organic electroluminescent device is basically same as a traditional OLED, and the cost is lowered.

## Description

### Technical Field

The present invention relates to the field of organic electroluminescence, and, in particular, relates to an organic electroluminescent device and a method for preparing the same.

### Background

The studies on organic electroluminescent (OLED) phenomenon can be traced back to as early as 1936. However, the early-stage light emitting devices required high driving voltage, but had low luminescent efficiency, and therefore did not draw much attention. In 1987, C. W. Tang, et al. successfully produced a small-molecular light emitting device driven by a low voltage (< 10 V), which rendered that organic electroluminescent phenomenon attracted extensive attention again. In 1990, J. H. Borroughes, et al. further reported the light emitting phenomenon of a polymer device under a low voltage, which opened a new area of research in polymer light emission. In 1998, Forrest, et al. used Alq₃ doped with a phosphorescent material PtOEP as a light emitting layer, and achieved an internal quantum efficiency of 23%, which meant a significant increase in the luminescent efficiency of the device. These research results effectively pushed the organic light emitting devices into a developing track to practicability, and also opened a new area of application of organic materials.

Organic electroluminescence may involve the following five processes: 1) injection of carriers, during which electrons and holes are injected from the cathode and the anode, respectively, to the organic functional film layer arranged between the electrodes under the effect of an applied electric field; 2) migration of carriers, during which the injected electrons and holes migrate to the light emitting layer through the electron transport layer and the hole transport layer, respectively; 3) recombination of carriers, during which electrons and holes combine in the light emitting layer to produce excitons; 4) migration of excitons, during which excitons migrate under the effect of the electric field, transfer their energy to the luminescent molecules, and excite electrons to transit from ground state to excited state; and 5) electroluminescence, during which the excited state is deactivated through energy irradiation to generate photons and release energy.

In these five processes, the energy-level match between the layers is very important, which directly affects the ultimate performance of the device. The HOMO value of the material for the hole transport layer is somewhat different from that of the material for the anode and the anode may release oxygen after long-time operation, which destroys the organic layer and results in dark spots. Therefore, a hole injection layer, which has a HOMO value between those of the anode and the hole transport layer, is normally inserted between the anode and the hole transport layer to facilitate hole injection. In addition, its film characteristics enable it to prevent oxygen in the anode from entering the OLED device, so as to prolong the life time of the device. Furthermore, the hole injection layer can also increase the adhesiveness between the hole transport layer and the anode, increase the hole injection contact, balance electron and hole injections, increase the proportion of exciton production from electrons and holes, and control or reduce the number of holes which do not participate in light emission, thereby increasing the efficiency of the device. A conventional material for the hole injection layer is poly(3,4-ethylenedioxythiophene) / poly(phenyl sulfonate) (PEDOT/PSS), the synthesis of which is expensive, which is not suitable for industrial production.

### Summary

In view of the above, it is necessary to provide an organic electroluminescent device employing a material with a lower cost of synthesis as the hole transport layer.

An organic electroluminescent device comprises a sequentially laminated structure comprising: a conductive substrate, a hole injection layer, a light emitting layer and a cathode layer; wherein the material for the hole injection layer is acid-doped polyaniline.

Preferably, the acid is an organic functional protonic acid or an inorganic protonic acid.

Preferably, the organic function protonic acid is at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate, sulfanilic acid and citric acid; and the inorganic protonic acid is at least one of hydrochloric acid, sulfuric acid and perchloric acid.

Preferably, the organic electroluminescent device further comprises a hole transport layer between the hole injection layer and the light emitting layer.

Preferably, the organic electroluminescent device further comprises an electron transport layer or an electron injection layer between the light emitting layer and the cathode layer.

Preferably, the organic electroluminescent device further comprises an electron transport layer and an electron injection layer between the light emitting layer and the cathode layer, wherein the electron transport layer is between the light emitting layer and the electron injection layer.

A method for preparing the above organic electroluminescent device comprises the steps of:
preparing a mixed sol of polyaniline and an acid in a mass ratio of polyaniline and the acid of 1:2 to 1:7;
subjecting a surface of a conductive substrate to a pretreatment;
spin-coating the mixed sol on the surface of the pretreated said conductive substrate, and drying to give a hole injection layer;
forming a light emitting layer on the hole injection layer; and
forming a cathode layer on the light emitting layer, and drying to give the organic electroluminescent device.

Preferably, the step for preparing the mixed sol comprises:
adding a solution of the acid to polyaniline in a mass ratio of polyaniline and the acid of 1:2 to 1:7, stirring while heating in an water bath or sonicating, washing, filtering,
and drying to give acid-doped polyaniline; and
formulating the above acid-doped polyaniline in de-ionized water or N-methyl pyrrolidone to give the mixed sol of polyaniline and the acid with a mass fraction of 1% to 20%.

Preferably, the step for forming the hole injection layer comprises:
dripping the mixed sol onto the conductive substrate, spin-coating with a spin coater at a rotating speed of 500 ~ 4000 rpm, and heating at 100 ~ 200°C for 15 ~ 60 min.

Preferably, the pretreatment step comprises: cleaning the conductive substrate, and subjecting the conductive substrate to oxygen plasma treatment, ozone-UV treatment, hydrogen peroxide treatment or acid treatment.

This kind of organic electroluminescent device employs acid-doped polyaniline as the material for the hole injection layer. Polyaniline has a relatively good conductivity and a relatively high stability, and is very suitable as a material for the hole injection layer. By doping with an acid, the solubility and the conductivity of polyaniline can be significantly improved. The organic electroluminescent device prepared by employing acid-doped polyaniline as the material for the hole injection layer has a luminescent performance comparable to that of the conventional organic electroluminescent devices. However, the cost for synthesizing acid-doped polyaniline is low; accordingly, it has a good marketing prospect.

### Brief Description of the Figures

Figure 1 shows a schematic structure of an organic electroluminescent device according to an embodiment;
Figure 2 shows a schematic structure of an organic electroluminescent device according to an embodiment;
Figure 3 shows a schematic structure of an organic electroluminescent device according to an embodiment;
Figure 4 shows a flow chart of a method for preparing the organic electroluminescent device shown in Figure 1; and
Figure 5 shows a schematic plot of luminance vs voltage for the organic electroluminescent device prepared in Example 12 and a traditional organic electroluminescent device.

### Specific Embodiments

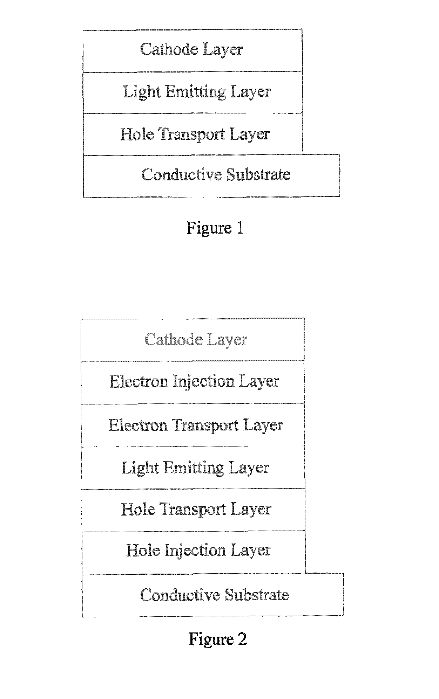

An organic electroluminescent device according to an embodiment is provided, which, as shown in Figure 1, comprises a sequentially laminated structure comprising: a conductive substrate, a hole injection layer, a light emitting layer and a cathode layer; wherein the material for the hole injection layer is acid-doped polyaniline.

A hole transport layer may be formed between the hole injection layer and the light emitting layer. One of an electron transport layer and an electron injection layer may also be formed between the light emitting layer and the cathode layer. Sequentially laminated electron transport layer and electron injection layer may also be formed between the light emitting layer and the cathode layer, wherein the electron transport layer is between the light emitting layer and the electron injection layer.

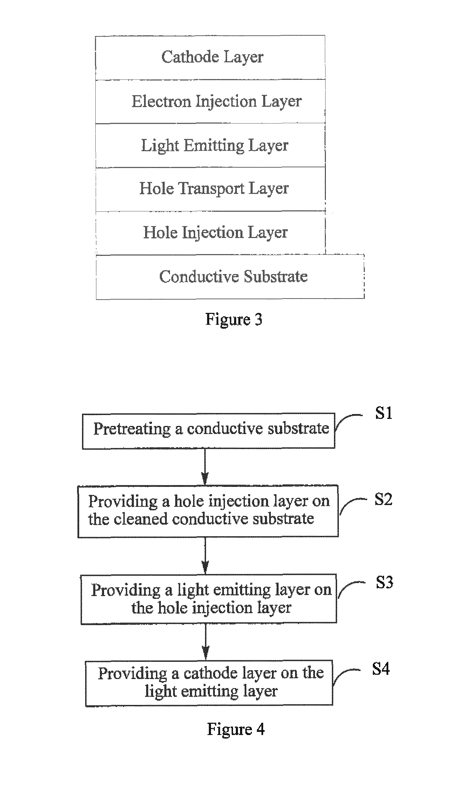

As described above, the organic electroluminescent device may have a variety of structures, such as specifically: sequentially laminated conductive substrate, hole injection layer, light emitting layer and cathode layer; sequentially laminated conductive substrate, hole injection layer, hole transport layer, light emitting layer, electron transport layer, electron injection layer and cathode layer, as shown in Figure 2; sequentially laminated conductive substrate, hole injection layer, hole transport layer, light emitting layer, electron injection layer and cathode layer, as shown in Figure 3; sequentially laminated conductive substrate, hole injection layer, hole transport layer, light emitting layer, electron transport layer and cathode layer; or the like.

The material for the conductive substrate may be indium tin oxide glass, fluorine-containing tin oxide glass, aluminum-doped zinc oxide, magnesium-indium oxide, nickel-tungsten oxide, metal nitride, metal selenide or metal sulfide.

The polyaniline raw material used in the present embodiment may be eigen state polyaniline, which may be commercially available.

The acid doping polyaniline may be an organic functional protonic acid or an inorganic protonic acid; wherein the organic function protonic acid may be at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate, sulfanilic acid and citric acid; and the inorganic protonic acid may be at least one of hydrochloric acid, sulfuric acid and perchloric acid.

The material for the hole transport layer may be N,N'-di(3-methylphenyl)-N,N'-diphenyl-4,4'-biphenyl diamine (TPD); poly(p-phenylene vinylene) or a derivative thereof (PPV), N,N'-(1-naphthyl)-N,N'-diphenyl-4,4'-biphenyl diamine (NPB), 1,3,5-triphenylbenzene (TDAPB), polyvinylcarbazole (PVK) or phthalocyanine copper CuPc.

The material for the light emitting layer may be tetra(tert-butyl)perylene (TBP), 4-(dicyano methyl)-2-butyl-6-(1,1,7,7-tetramethyljulolidine-9-vinyl)-4H-pyran (DCJTB), 9,10-di-β-naphthalene anthracene (AND), di(2-methyl-8-hydroxyquinolyl)-(4-diphenol) aluminum (BALQ), 4-(dicyanomethylene)-2-isopropyl-6-(1,1,7,7-tetramethyljulolidine-9-vinyl)-4H-pyran (DCJTI), dimethyl quinacridone (DMQA), 8-hydroxyquinoline aluminum (Alq3) or poly(p-phenylene vinylene) or a derivative thereof (PPV).

The material for the electron transport layer may be 2-(4-biphenyl)-5-(4-tert-butyl)phenyl-1,3,4-oxadiazole (PBD), 8-hydroxyquinoline aluminum (Alq₃), 2,5-di(1-naphthyl)-1,3,4-diazole (BND), 1,2,4-triazole derivative (such as TAZ), N-aryl benzimidazole (TPBI) or quinoxaline derivative (TPQ).

The material for the electron injection layer may be LiF, LiO₂, Cs₂O, Al₂O₃, NaF, CsF, CaF₂, MgF₂, NaCl, KCl, RbCl, LiBO₂ or K₂SiO₃.

The material for the cathode layer may be Al, Au, Mg/Ag alloy, Al/Mg alloy, Al/Ca alloy or Al/Li alloy.

Figure 4 shows a method for preparing the above organic electroluminescent device, which comprises the following steps.

S1: Subjecting a conductive substrate to a pretreatment.

A conductive substrate is provided, subjected to photolithography, cut into a suitable size, washed, and then subjected to oxygen plasma treatment, ozone-UV treatment, hydrogen peroxide treatment or acid treatment (including mixed-acid treatment, such as aqua regia treatment), to complete the pretreatment.

S2: Forming a hole injection layer on the conductive substrate.

Polyaniline is weighed, to which is added an acid solution having a mass concentration of 10% to 40%, while controlling the mass ratio of polyaniline and the acid to be 1:2 to 1:7; the mixture is stirred while being heated in an water bath or sonicated, washed, filtered, and dried to give acid-doped polyaniline;
the above doped polyaniline is formulated in de-ionized water or N-methyl pyrrolidone to give a mixed sol of polyaniline and the acid with a mass fraction of 1% to 20%; and
the above mixed sol of polyaniline and the acid is dripped onto the pretreated conductive substrate, spin-coated with a spin coater at a rotating speed of 500 ~ 4000 rpm for 30 s, and heated at 100 ~ 200 °C for 15 ~ 60 min; after cooling, a hole injection layer is formed.

S3: Forming a light emitting layer on the hole injection layer.

The light emitting layer is formed on the hole injection layer by spin coating, vapor deposition, sputtering, jet plating, chemical vapor deposition or electrochemical deposition.

S4: Forming a cathode layer on the light emitting layer.

The cathode layer is formed on the light emitting layer by spin coating, vapor deposition, sputtering, jet plating, chemical vapor deposition or electrochemical deposition.

The above method for preparing the organic electroluminescent device may further comprise forming a hole transport layer between the hole injection layer and the light emitting layer and sequentially forming an electron transport layer and an electron injection layer between the light emitting layer and the cathode layer by spin coating, vapor deposition, sputtering, jet plating, chemical vapor deposition or electrochemical deposition.

A conventional material for the hole injection layer is poly(3,4-ethylenedioxythiophene) / poly(phenyl sulfonate) (PEDOT/PSS), the synthesis of which is expensive, which is not suitable for industrial production. Polyaniline has a relatively good conductivity and a relatively high stability, and is very suitable as a material for the hole injection layer after being doped with an acid. In addition, by adjusting the doping ratio of the acid, solutions of acid-doped polyaniline with different mobilities may be obtained. In respect of the electron mobility of various electron transport materials, the hole injection efficiency is adjusted to optimize the hole-charge recombination probability. Meanwhile, by using an acid which has a counter ion with a relatively large volume as the doping acid, the chain alignment of polyaniline and the stability of the device may be improved. The organic electroluminescent device prepared by employing acid-doped polyaniline as the material for the hole injection layer shows a luminescent performance comparable to that of the conventional organic electroluminescent devices. However, the cost for synthesizing acid-doped polyaniline is low; accordingly, it has a good marketing prospect.

The organic electroluminescent device and the method for the preparation thereof are further described hereinafter in combination with the Figures and specific Examples.

In Examples 1 to 11, the material for the hole transport layer is N,N'-di(3-methylphenyl)-N,N'-diphenyl-4,4'-biphenyl diamine (TPD); the material for the light emitting layer is tetra(tert-butyl)perylene (TBP); the material for the electron transport layer is 2-(4-biphenyl)-5-(4-tert-butyl)phenyl-1,34-oxadxazole (PBD); the material for the electron injection layer material is LiF; and the material for the cathode layer is Al.

In Example 12, the material for the hole transport layer is N,N'-(1-naphthyl)-N,N'-diphenyl-4,4'-biphenyl diamine (NPB); the material for the light emitting layer is 8-hydroxyquinoline aluminum (Alq₃); the material for the electron injection layer is LiF; and the material for the cathode layer is Al.

### Example 1

The organic electroluminescent device was prepared as follows. Eigen state polyaniline having a mass concentration of 10% is weighed, to which is added a solution of p-styrene sulfonic acid, so that the mass ratio of polyaniline and p-styrene sulfonic acid is 1:6. The mixture is stirred while being heated in a water bath. After reacting for a certain time, the mixture is washed with p-styrene sulfonic acid, filtered, and finally dried to give the doped polyaniline. By using de-ionized water as a solvent, the above acid-doped polyaniline is completely dissolved to formulate an aqueous solution of polyaniline having a mass fraction of 1%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 30 W for 5 min. The main role is to improve the wettability and the adsorption of the surface of the conductive glass and to further remove organic pollutants from the surface of the conductive glass. After treatment, the conductive substrate is dried and stored for future use. The formulated aqueous solution of polyaniline is dripped on a spin coater, and spin coated on the indium tin oxide glass at a rotating speed of 2000 rpm for 30 s. The coated conductive substrate is then heated in an oven at 150 °C for 50 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 2

Eigen state polyaniline having a mass concentration of 15% is weighed, to which is added a solution of p-styrene sulfonic acid, so that the mass ratio of polyaniline and p-styrene sulfonic acid is 1:2. The mixture is stirred while being heated in a water bath. After reacting for a certain time, the mixture is washed with p-styrene sulfonic acid, filtered, and finally dried to give the doped polyaniline. By using de-ionized water as a solvent, the above acid-doped polyaniline is completely dissolved to formulate an aqueous solution of polyaniline having a mass fraction of 1%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 50 W for 10 min. After treatment, the conductive substrate is dried and stored for future use. The formulated aqueous solution of polyaniline is dripped on a spin coater, and spin coated on the indium tin oxide glass at a rotating speed of 1800 rpm for 30 s. The coated conductive substrate is then heated in an oven at 125 °C for 45 min. After drying, the hole injection layer for organic electroluminescence is obtained, onto which the hole transport layer, the light emitting layer, the electron injection layer and the cathode layer are prepared by spin coating, vapor deposition, sputtering, jet plating, chemical vapor deposition or electrochemical deposition. Finally, the organic electroluminescent device is obtained.

### Example 3

Eigen state polyaniline having a mass concentration of 10% is weighed, to which is added a solution of p-styrene sulfonic acid, so that the mass ratio of polyaniline and p-styrene sulfonic acid is 1:7. The mixture is stirred while being heated in a water bath. After reacting for a certain time, the mixture is washed with p-styrene sulfonic acid, filtered, and finally dried to give the doped polyaniline. By using de-ionized water as a solvent, the above acid-doped polyaniline is completely dissolved to formulate an aqueous solution of polyaniline having a mass fraction of 10%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 30 W for 8 min. After treatment, the conductive substrate is dried and stored for future use. The formulated aqueous solution of polyaniline is dripped on a spin coater, and spin coated on the indium tin oxide glass at a rotating speed of 500 rpm for 30 s. The coated conductive substrate is then heated in an oven at 180°C for 35 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 4

The solution of p-styrene sulfonic acid in Example 1 is replaced with a solution of p-toluene sulfonic acid. Eigen state polyaniline having a mass concentration of 12% is weighed, to which is added a solution of p-toluene sulfonic acid, so that the mass ratio of polyaniline and p-toluene sulfonic acid is 1:4. The mixture is stirred while being heated in a water bath. After reacting for a certain time, the mixture is washed with p-toluene sulfonic acid, filtered, and fmally dried to give the doped polyaniline. By using de-ionized water as a solvent, the above acid-doped polyaniline is completely dissolved to formulate an aqueous solution of polyaniline having a mass fraction of 15%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 30 W for 12 min. After treatment, the conductive substrate is dried and stored for future use. The formulated aqueous solution of polyaniline is dripped on a spin coater, and spin coated on the indium tin oxide glass at a rotating speed of 3000 rpm for 30 s. The coated conductive substrate is then heated in an oven at 200 °C for 40 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 5

The solution of p-styrene sulfonic acid in Example 1 is replaced with a solution of p-toluene sulfonic acid. Eigen state polyaniline having a mass concentration of 20% is weighed, to which is added a solution of p-toluene sulfonic acid, so that the mass ratio of polyaniline and p-toluene sulfonic acid is 1:3. The mixture is stirred while being heated in a water bath. After reacting for a certain time, the mixture is washed with p-toluene sulfonic acid, filtered, and finally dried to give the doped polyaniline. By using de-ionized water as a solvent, the above acid-doped polyaniline is completely dissolved to formulate an aqueous solution of polyaniline having a mass fraction of 20%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 25 W for 10 min. After treatment, the conductive substrate is dried and stored for future use. The formulated aqueous solution of polyaniline is dripped on a spin coater, and spin coated on the indium tin oxide glass at a rotating speed of 2500 rpm for 30 s. The coated conductive substrate is then heated in an oven at 120 °C for 30 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 6

The solution of p-styrene sulfonic acid in Example 1 is replaced with a solution of p-toluene sulfonic acid. A certain amount of eigen state polyaniline is weighed, to which is added a solution of p-toluene sulfonic acid having a mass concentration of 25%, so that the mass ratio of polyaniline and p-toluene sulfonic acid is 1:4. The mixture is stirred while being heated in a water bath. After reacting for a certain time, the mixture is washed with p-toluene sulfonic acid, filtered, and finally dried to give the doped polyaniline. By using de-ionized water as a solvent, the above acid-doped polyaniline is completely dissolved to formulate an aqueous solution of polyaniline having a mass fraction of 1%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 10 W for 15 min. After treatment, the conductive substrate is dried and stored for future use. The formulated aqueous solution of polyaniline is dripped on a spin coater, and spin coated on the indium tin oxide glass at a rotating speed of 2500 rpm for 30 s. The coated conductive substrate is then heated in an oven at 150 °C for 45 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 7

The solution of p-styrene sulfonic acid in Example 1 is replaced with a solution of sulfuric acid. A certain amount of eigen state polyaniline is weighed, to which is added a solution of sulfuric acid having a mass concentration of 35%, so that the mass ratio of polyaniline and sulfuric acid is 1:5. The mixture is stirred while being heated in a water bath. After reacting for a certain time, the mixture is washed with sulfuric acid, filtered, and finally dried to give the doped polyaniline. By using de-ionized water as a solvent, the above acid-doped polyaniline is completely dissolved to formulate an aqueous solution of polyaniline having a mass fraction of 10%, which is stored for future use. The indium tin oxide glass in Example 1 is replaced with foamed copper, which is cut into a required size, washed with a detergent, treated with diluted hydrochloric acid to remove oxides from the surface, and then sonicated sequentially in de-ionized water, acetone and ethanol, each for 15 min. The conductive substrate is dried and stored for future use. The formulated aqueous solution of polyaniline is dripped on a spin coater, and spin coated on the indium tin oxide glass at a rotating speed of 2500 rpm for 30 s. The coated conductive substrate is then heated in an oven at 150 °C for 45 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 8

The solution of p-styrene sulfonic acid in Example 1 is replaced with a solution of sulfuric acid. A certain amount of eigen state polyaniline is weighed, to which is added a solution of sulfuric acid having a mass concentration of 40%, so that the mass ratio of polyaniline and sulfuric acid is 1:7. The mixture is stirred while being heated in a water bath. After reacting for a certain time, the mixture is washed with sulfuric acid, filtered, and finally dried to give the doped polyaniline. By using de-ionized water as a solvent, the above acid-doped polyaniline is completely dissolved to formulate an aqueous solution of polyaniline having a mass fraction of 1%, which is stored for future use. The indium tin oxide glass in Example 1 is replaced with foamed copper, which is cut into a required size, washed with a detergent, treated with diluted hydrochloric acid to remove oxides from the surface, and then sonicated sequentially in de-ionized water, acetone and ethanol, each for 15 min. The conductive substrate is dried and stored for future use. The formulated aqueous solution of polyaniline is dripped on a spin coater, and spin coated on the indium tin oxide glass at a rotating speed of 4000 rpm for 30 s. The coated conductive substrate is then heated in an oven at 120 °C for 50 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 9

The solution of p-styrene sulfonic acid in Example 1 is replaced with a solution of sulfosalicylic acid. A certain amount of eigen state polyaniline is weighed, to which is added a solution of sulfosalicylic acid having a mass concentration of 32%, so that the mass ratio of polyaniline and sulfuric acid is 1:6. The mixture is stirred while being heated in a water bath. After reacting for a certain time, the mixture is washed with sulfosalicylic acid, filtered, and finally dried to give the doped polyaniline. By using N-methyl pyrrolidone as a solvent, the above acid-doped polyaniline is completely dissolved to formulate a solution of polyaniline having a mass fraction of 20% in pyrrolidone, which is stored for future use. The indium tin oxide glass in Example 1 is replaced with fluorine-doped tin oxide glass, which is washed with a detergent, soaked in isopropanol overnight to remove residue grease from the surface, and then sonicated sequentially in de-ionized water, acetone, ethanol and isopropanol, each for 15 min. The conductive substrate is dried and stored for future use. The formulated aqueous solution of polyaniline is dripped on a spin coater, and spin coated on the indium tin oxide glass at a rotating speed of 2800 rpm for 30 s. The coated conductive substrate is then heated in an oven at 100 °C for 35 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 10

The solution of p-styrene sulfonic acid in Example 1 is replaced with a solution of sulfosalicylic acid. A certain amount of eigen state polyaniline is weighed, to which is added a solution of sulfosalicylic acid having a mass concentration of 10%, so that the mass ratio of polyaniline and sulfuric acid is 1:2. The mixture is stirred while being heated in a water bath. After reacting for a certain time, the mixture is washed with sulfosalicylic acid, filtered, and finally dried to give the doped polyaniline. By using N-methyl pyrrolidone as a solvent, the above acid-doped polyaniline is completely dissolved to formulate a solution of polyaniline having a mass fraction of 12% in pyrrolidone, which is stored for future use. The indium tin oxide glass in Example 1 is replaced with fluorine-doped tin oxide glass, which is washed with a detergent, soaked in isopropanol overnight to remove residue grease from the surface, and then sonicated sequentially in de-ionized water, acetone, ethanol and isopropanol, each for 15 min. The conductive substrate is dried and stored for future use. The formulated aqueous solution of polyaniline is dripped on a spin coater, and spin coated on the indium tin oxide glass at a rotating speed of 3500 rpm for 30 s. The coated conductive substrate is then heated in an oven at 180 °C for 60 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 11

The solution of p-styrene sulfonic acid in Example 1 is replaced with a solution of sulfosalicylic acid. A certain amount of eigen state polyaniline is weighed, to which is added a solution of sulfosalicylic acid having a mass concentration of 15%, so that the mass ratio of polyaniline and sulfuric acid is 1:7. The mixture is stirred while being heated in a water bath. After reacting for a certain time, the mixture is washed with sulfosalicylic acid, filtered, and finally dried to give the doped polyaniline. By using N-methyl pyrrolidone as a solvent, the above acid-doped polyaniline is completely dissolved to formulate a solution of polyaniline having a mass fraction of 5% in pyrrolidone, which is stored for future use. The indium tin oxide glass in Example 1 is replaced with fluorine-doped tin oxide glass, which is washed with a detergent, soaked in isopropanol overnight to remove residue grease from the surface, and then sonicated sequentially in de-ionized water, acetone, ethanol and isopropanol, each for 15 min. The conductive substrate is dried and stored for future use. The formulated aqueous solution of polyaniline is dripped on a spin coater, and spin coated on the indium tin oxide glass at a rotating speed of 1000 rpm for 30 s. The coated conductive substrate is then heated in an oven at 110 °C for 40 min. After drying, the hole injection layer for organic electroluminescence is obtained, onto which the hole transport layer, the light emitting layer, the electron transport layer, the electron injection layer and the cathode layer are prepared by spin coating, vapor deposition, sputtering, jet plating, chemical vapor deposition or electrochemical deposition. Finally, the organic electroluminescent device is obtained.

### Example 12

A certain amount of eigen state polyaniline is weighed, to which is added a solution of p-styrene sulfonic acid having a mass concentration of 25%, so that the mass ratio of polyaniline and p-styrene sulfonic acid is 1:7. The mixture is stirred while being heated in a water bath. After reacting for a certain time, the mixture is washed with p-styrene sulfonic acid, filtered, and finally dried to give the doped polyaniline. By using de-ionized water as a solvent, the above acid-doped polyaniline is completely dissolved to formulate an aqueous solution of polyaniline having a mass fraction of 10%, which is stored for future use. An indium tin oxide glass is cut into a required size, and then sonicated sequentially in a detergent, de-ionized water, acetone, ethanol and isopropanol, each for 15 min. After cleaning, the conductive glass is subjected to oxygen plasma treatment at a power of 45 W for 12 min. After treatment, the conductive substrate is dried and stored for future use. The formulated aqueous solution of polyaniline is dripped on a spin coater, and spin coated on the indium tin oxide glass at a rotating speed of 3000 rpm for 30 s. The coated conductive substrate is then heated in an oven at 160°C for 30 min. After drying, the hole injection layer for organic electroluminescence is obtained, onto which the hole transport layer, the light emitting layer, the electron injection layer and the cathode layer are prepared by spin coating, vapor deposition, sputtering, jet plating, chemical vapor deposition or electrochemical deposition. Finally, the organic electroluminescent device is obtained.

A traditional organic electroluminescent device is prepared in the same manner, wherein the material for the hole injection layer material is PEDOT/PSS.

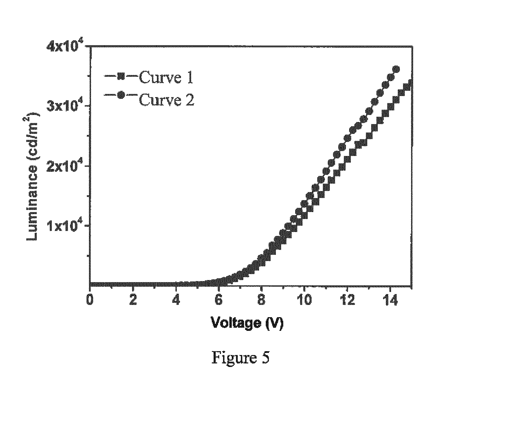

Figure 5 shows a schematic plot of luminance (in cd/m²) vs voltage (in V) for the organic electroluminescent device prepared in Example 12 and a traditional organic electroluminescent device, in which Curve 1 refers to the organic electroluminescent device of Example 12, and Curve 2 refers to the traditional organic electroluminescent device. Referring to the figure and comparing the organic electroluminescent device of Example 12 prepared by using acid-doped polyaniline as the hole injection layer with the traditional organic electroluminescent device prepared by using PEDOT/PSS as the hole injection layer under the same conditions, the starting voltage and the brightness of the organic electroluminescent device of Example 12 are substantially the same as those of the traditional organic electroluminescent device. Considering the superior cost efficiency of acid-doped polyaniline, use thereof as the material for the hole injection layer has a good marketing prospect.

The above Examples illustrate only several embodiments of the present invention, and the description is specific and in detail. However, this can not be understood as a limitation to the scope of the present invention. It should be noted that, for a person having ordinary skill in the art, certain modifications and improvements may be made without departing from the inventive concept, which shall be within the scope sought protection in the present invention. Therefore, the scope sought protection in the present invention should be subject to the appended claims.

## Claims

1. An organic electroluminescent device, comprising a sequentially laminated structure comprising: a conductive substrate, a hole injection layer, a light emitting layer and a cathode layer; **characterized in that** the material for the hole injection layer is acid-doped polyaniline.

2. The organic electroluminescent device according to Claim 1, **characterized in that** the acid is an organic functional protonic acid or an inorganic protonic acid.

3. The organic electroluminescent device according to Claim 2, **characterized in that** the organic functional protonic acid is at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate, sulfanilic acid and citric acid; and the inorganic protonic acid is at least one of hydrochloric acid, sulfuric acid and perchloric acid.

4. The organic electroluminescent device according to any one of Claims 1 to 3, **characterized in that** the organic electroluminescent device further comprises a hole transport layer between the hole injection layer and the light emitting layer.

5. The organic electroluminescent device according to any one of Claims 1 to 3, **characterized in that** the organic electroluminescent device further comprises an electron transport layer or an electron injection layer between the light emitting layer and the cathode layer.

6. The organic electroluminescent device according to any one of Claims 1 to 3, **characterized in that** the organic electroluminescent device further comprises an electron transport layer and an electron injection layer between the light emitting layer and the cathode layer, wherein the electron transport layer is between the light emitting layer and the electron injection layer.

7. A method for preparing the organic electroluminescent device according to any one of Claims 1 to 3, **characterized in that** the method comprises the steps of:
preparing a mixed sol of polyaniline and an acid in a mass ratio of polyaniline and the acid of 1:2 to 1:7;
subjecting a surface of a conductive substrate to a pretreatment;
spin-coating the mixed sol on the surface of the pretreated said conductive substrate,
and drying to give a hole injection layer;
forming a light emitting layer on the hole injection layer; and
forming a cathode layer on the light emitting layer, and drying to give the organic electroluminescent device.

8. The method for preparing the organic electroluminescent device according to Claim 7, **characterized in that** the step for preparing the mixed sol comprises:
adding a solution of the acid to polyaniline in a mass ratio of polyaniline and the acid of 1:2 to 1:7, stirring while heating in an water bath or sonicating, washing, filtering,
and drying to give acid-doped polyaniline; and
formulating the above acid-doped polyaniline in de-ionized water or N-methyl pyrrolidone to give the mixed sol of polyaniline and the acid with a mass fraction of 1% to 20%.

9. The method for preparing the organic electroluminescent device according to Claim 7, **characterized in that** the step for forming the hole injection layer comprises:
dripping the mixed sol onto the conductive substrate, spin-coating with a spin coater at a rotating speed of 500 ~ 4000 rpm, and heating at 100 ~ 200 °C for 15 ~ 60 min.

10. The method for preparing the organic electroluminescent device according to Claim 7, **characterized in that** the pretreatment step comprises: cleaning the conductive substrate, and subjecting the conductive substrate to oxygen plasma treatment, ozone-UV treatment, hydrogen peroxide treatment or acid treatment.
